(19) Europäisches Patentamt / European Patent Office / Office européen des brevets

(11) **EP 2 831 172 B1**

(12) **EUROPEAN PATENT SPECIFICATION**

(45) Date of publication and mention
of the grant of the patent:
**02.05.2018 Bulletin 2018/18**

(21) Application number: **12873332.6**

(22) Date of filing: **29.03.2012**

(51) Int Cl.:
*C08L 63/00* (2006.01)     *H01B 3/40* (2006.01)
*C08K 5/09* (2006.01)     *C08K 3/22* (2006.01)
*C08K 3/34* (2006.01)     *C08G 59/42* (2006.01)

(86) International application number:
**PCT/CN2012/073232**

(87) International publication number:
**WO 2013/143097 (03.10.2013 Gazette 2013/40)**

(54) **CURABLE COMPOSITIONS**

HÄRTBARE ZUSAMMENSETZUNGEN

COMPOSITIONS DURCISSABLES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.02.2015 Bulletin 2015/06**

(73) Proprietor: **Dow Global Technologies LLC
Midland, MI 48674 (US)**

(72) Inventors:
• **JI, Minglei
Shanghai 200433 (CN)**
• **LI, Yongjiang
Shanghai 201100 (CN)**

• **ZHANG, Yi
Shanghai 200042 (CN)**

(74) Representative: **Beck Greener
Fulwood House
12 Fulwood Place
London WC1V 6HR (GB)**

(56) References cited:
WO-A1-2011/075215     CN-A- 1 908 063
DE-A1-102010 019 723     JP-A- H03 200 858
JP-A- H06 228 414     US-A- 4 113 791
US-A- 4 127 695     US-A- 6 040 397
US-B2- 7 008 981     US-B2- 7 271 206

EP 2 831 172 B1

**Description**

BACKGROUND OF THE INVENTION

Field of the Invention

The present invention is related to a curable resin composition and articles made therefrom. More specifically, the present invention is related to a curable epoxy resin composition suitable for the preparation of, for example, an insulator for high-voltage gas insulated switchgear applications.

Description of Background and Related Art

Heretofore, gas insulated switchgears (GIS) have been known to be used in power transmission and distribution networks for decades, especially for high-voltage applications for example in applications using voltages of from 110 kV to 1100 kV. A GIS is used to break circuits when an electrical problem occurs.

Sulfur hexafluoride ($SF_6$) gas is typically used in GIS equipment to insulate conductors such as busbars and circuit breakers from the steel shell which is used as an outer-layer surrounding the equipment, $SF_6$ gas is more commonly used because $SF_6$ has a high dielectric strength and an ability to distinguish arcs generated during current switch off and switch on in GIS. There are lots of insulators used as spacers and valves inside a GIS to separate different parts and chambers to prevent the leakage of $SF_6$ gas. Under GIS working conditions, the temperature and pressure inside a GIS can exceed 100 °C and 1 MPa, respectively, when the current in the GIS is switched off. Therefore, in order to guarantee the reliability of GIS equipment, the insulator needs to have high mechanical strength, thermal resistance and toughness under high pressure and temperature conditions.

JP2755666B discloses a mixture of two epoxy resins, one with an epoxide equivalent weight (EEW) of 400-1000 and one with an EEW of ≤ 250, to make a cured thermoset for electrical insulation applications. The high mixing viscosity of the mixture disclosed in JP2103220A makes it difficult to process the mixture, i.e. the processability of the mixture is poor. In addition, the thermal resistance of the cured thermoset product from the above mixture is low.

JP2011001424A discloses an elastomer tougher added to an epoxy resin composition to increase the toughness of the final thermoset product made from the epoxy resin composition. However, the elastomer tougher reduces the mechanical strength of the final thermoset product such as when used as a spacer, especially the modulus and tensile strength of the final thermoset product which are two important parameters to obtain a stable mechanical performance of the spacer used in a GIS during the spacer's operation.

JP3247619A discloses producing an epoxy resin composition and insulation structures from the epoxy resin composition wherein the composition comprises an epoxy resin having at least two epoxy groups per molecule, a polycarboxylic acid anhydride, and an inorganic filler. In JP3247619A, the epoxy resin component of the composition consists of a mixture of a glycidyl ester epoxy resin and a cycloaliphatic epoxy resin in a weight ratio of 95/5 to 60/40. As aforementioned, the properties of modulus and tensile strength are two important parameters to obtain stable mechanical performances of spacers used in GIS during the spacers operation; and these two properties of the final thermoset product disclosed in JP3247619A are reduced when preparing the thermoset product according to the teaching of JP3247619A.

Epoxy resin compositions for insulators for high-voltage gas insulated switchgear applications are also discloses in JP-A-03200858.

Higher working temperatures and gas pressures in GIS are required when the GIS is used in applications requiring higher voltage levels to provide the GIS with enough insulation capability. In order to meet the harsh requirements of a higher voltage (for example 1100kV) GIS line, both the mechanical and thermal resistance properties of the resin composition used to make the high-voltage GIS line need to be improved compared to the resin compositions disclosed in the above prior art references.

SUMMARY OF THE INVENTION

The present invention solves the problems of the prior art epoxy resin compositions by providing an epoxy resin composition having a mixture of three or more different epoxy resins, in addition to an anhydride curing agent and a filler. Advantageously, one or more of the three epoxy resins of the composition can be adjusted to achieve a final resin thermoset product made from the composition exhibiting a significant improved performance by balancing the properties of the resin product in terms of the resin product's processability, thermal resistance properties, mechanical properties, and/or electrical properties.

The present invention provides a composition containing an epoxy group to anhydride group ratio of from about 1:0.75 to about 1:0.85. In the present invention, an excess of epoxy groups, in the above epoxy to anhydride ratio, advantageously achieves a significant improved performance.

The present invention also provides a composition with a high molecular weight (Mw) (e.g. greater than about 800) of an epoxy resin to improve the flexibility and toughness of the final cured thermoset product without the use of an elastomer toughener, i.e., an elastomer toughener is not required in the formulation of the present invention to increase toughness. For example, in one embodiment, the epoxy resin can be a bisphenol A type epoxy resin which is readily available.

The present invention also provides a composition which employs filler material such as an aluminum oxide in the absence of a pH-adjuster to form electric/electronic components that can be used under high voltage conditions.

The present invention is directed to a curable epoxy resin composition or formulation useful for making an insulator for a high-voltage gas insulated switchgear including (A) an epoxy resin composition comprising a mixture of: (A1) at least one solid epoxy resin, (A2) at least one novolac epoxy resin, and (A3) at least one cycloaliphatic epoxy resin; (B) at least one anhydride hardener; (C) at least one filler; and (D) optionally, at least one catalyst or at least one accelerator, wherein "solid epoxy resin" means an epoxy resin with a softening point no less than 50 °C and the formulation contains an epoxy group to anhydride group ratio of from 1:0.75 to 1:0.85.

In one preferred embodiment of the present invention, a mixture of (A1) at least one high Mw bisphenol A type epoxy resin with an EEW of about 500, (A2) at least one novolac epoxy resin, and (A3) at least one cycloaliphatic epoxy resin, is used as the epoxy resin component (A) of the formulation of the present invention.

In another preferred embodiment, at least one liquid anhydride such as methyl tetrahydrophthalic anhydride (MTHPA) or methyl hexahydrophthalic anhydride (MHHPA) is used as the anhydride hardener component of the formulation of the present invention.

In still another preferred embodiment, at least one filler material such as an inorganic alumina with or without surface treatment is used as the filler component of the formulation of the present invention.

The present invention formulation shows a superior balance of different properties including resin viscosity and composition viscosity; and the cured thermoset product based on the present invention formulation shows a superior balance of various properties including for example glass transition temperature, tensile strength, impact strength, and fracture toughness.

Another embodiment of the present invention includes a process for making the above curable composition or formulation.

In one embodiment, the present invention formulation is suitable for the preparation of an insulator useful for a high-voltage gas insulated switchgear.

Yet another embodiment of the present invention includes a process for manufacturing an insulator useful for a high-voltage gas insulated switchgear wherein the insulator is made from the above composition.

DETAILED DESCRIPTION OF THE INVENTION

"High-voltage" herein means a voltage level of 110 kV and greater.

"Solid epoxy resin" herein means an epoxy resin with a softening point no less than 50 °C.

In the broadest scope of the present invention, a curable epoxy resin formulation is provided for making an insulator for a high-voltage gas insulated switchgear. The curable epoxy resin formulation for making the insulator for a high-voltage gas insulated switchgear includes for example: (A) an epoxy resin composition comprising a mixture of: (A1) at least one solid epoxy resin, (A2) at least one novolac epoxy resin, and (A3) at least one cycloaliphatic epoxy resin; (B) at least one anhydride hardener; (C) at least one filler; and (D) optionally, at least one catalyst or at least one accelerator, wherein "solid epoxy resin" means an epoxy resin with a softening point no less than 50 °C and the formulation contains an epoxy group to anhydride group ratio of from 1:0.75 to 1:0.85.

The solid epoxy resin useful in the present invention may include for example any epoxy resin with a softening point of no less than 50 °C. In one preferred embodiment, the solid epoxy resin may include for example a bisphenol A type epoxy resin such as D.E.R. 671, an epoxy resin product commercially available from The Dow Chemical Company.

The solid epoxy resin may have an epoxy equivalent weight (EEW) of from about 400 to about 600 in one embodiment and from about 450 to about 550 in another embodiment.

The concentration of the solid epoxy resin used in the curable formulation of the present invention may range generally from about 5 weight percent (wt %) to about 16 wt % in one embodiment, from about 6 wt % to about 14 wt % in another embodiment, and from about 7 wt % to about 13 wt % in still another embodiment, based on the total weight of the composition. If the solid epoxy resin used in the present invention is above the concentration of about 16 wt %, the mechanical strength and the thermal resistance of the cured thermoset may begin to decrease. Also, the composition viscosity may begin to increase and it may be difficult to fully degas (so as to eliminate residual bubbles and voids in the final thermoset) the composition during sample preparation. Any residual bubbles and voids in the cured thermoset may decrease the electric properties of the thermoset such as its dielectric strength and partial discharge.

If the solid epoxy resin used in the present invention is below the concentration of about 5 wt %, the toughness of the cured thermoset may begin to decrease. Also, the composition viscosity may begin to decrease and it may cause the filler material in the composition, such as the alumina filler, to settle out of the composition and produce sedimentation during sample preparation and curing. Such sedimentation may cause inhomogeneous filler distribution in the cured thermoset.

In one preferred embodiment, a solid epoxy resin such as a bisphenol A type epoxy resin may be used at about 40 wt % to about 60 wt % of the epoxy resin mixture and from about 45 wt % to about 55 wt % of the epoxy resin mixture in another embodiment. For example, in another embodiment, the bisphenol A type epoxy resin may be a commercial product, such as D.E.R. 671, which is an epoxy resin having an EEW of 500 and commercially available from The Dow Chemical Company. D.E.R. 671 is solid at room temperature (about 25 °C).

Other solid epoxy resins that may be used in the present invention may be any of the solid epoxy resins known in the art such as the solid epoxy resins described in Lee, H. and Neville, K., Handbook of Epoxy Resins, McGraw-Hill Book Company, New York, 1967, Chapter 2, pages 2-1 to 2-27, incorporated herein by reference.

The novolac epoxy resin useful in the present invention may include one or more novolac epoxy resins. For example, the novolac epoxy resin may include condensates of phenols with formaldehyde obtained under acid conditions, including for example phenol novolacs, bisphenol A novolacs, cresol novolacs, or mixtures thereof. In one preferred embodiment, the novolac epoxy resin useful in the present invention may include for example, D.E.N. 438, a novolac epoxy resin product commercially available from The Dow Chemical Company.

The concentration of the novolac epoxy resin used in the curable formulation of the present invention may range generally from about 2.5 wt % to about 11 wt % in one embodiment, from about 3 wt % to about 9 wt % in another embodiment, and from about 4 wt % to about 8 wt % in still another embodiment, based on the total weight of the composition. If the novolac epoxy resin used in the present invention is above the concentration of about 11 wt %, the toughness of the cured thermoset may begin to decrease. Also, the composition viscosity may begin to increase and it may be difficult to fully degas the composition during sample preparation. Any residual bubbles and voids in the cured thermoset may decrease the electric properties of the thermoset such as its dielectric strength and partial discharge.

If the novolac epoxy resin used in the present invention is below the concentration of about 2.5 wt %, the mechanical strength and the thermal resistance of the cured thermoset may begin to decrease. Also the composition viscosity may begin to decrease and it may cause filler material sedimentation in the composition during sample preparation and curing. Such sedimentation may cause inhomogeneous filler distribution in the cured thermoset.

In one preferred embodiment, a novolac epoxy resin may be used at about 20 wt % to about 40 wt % of the epoxy resin mixture and from about 25 wt % to about 35 wt % of the epoxy resin mixture in another embodiment. For example, in another embodiment, the novolac epoxy resin may be a commercial product, such as D.E.N. 438, which is a novolac epoxy resin having an EEW of about 174 and commercially available from The Dow Chemical Company. D.E.N. 438 is semi-solid at room temperature.

Other novolac epoxy resins that may be used in the present invention may be any of the novolac epoxy resins known in the art such as the novolac epoxy resins described in Lee, H. and Neville, K., Handbook of Epoxy Resins, McGraw-Hill Book Company, New York, 1967, Chapter 2, pages 2-1 to 2-27, incorporated herein by reference.

The cycloaliphatic epoxy resin useful in the present invention may include one or more cycloaliphatic epoxy resin such as for example a hydrocarbon compound containing at least one non-aryl hydrocarbon ring structure and containing an epoxy group. The epoxy group in the cycloaliphatic epoxy compound may include for example an epoxy group fused to the ring structure and/or an epoxy group residing on an aliphatic substituent of the ring structure. In one preferred embodiment, the cycloaliphatic epoxy resin may include for example E.R.L. 4221, an epoxy resin product commercially available from The Dow Chemical Company.

The concentration of the epoxy resin used in the curable formulation of the present invention may range generally from about 1 wt % to about 8 wt % in one embodiment, from about 1.5 wt % to about 7 wt % in another embodiment, and from about 2 wt % to about 6 wt % in still another embodiment, based on the total weight of the composition. If the cycloaliphatic epoxy resin used in the present invention is above the concentration of about 8 wt %, the toughness and the mechanical strength of the cured thermoset may begin to decrease. Also, the composition viscosity may begin to decrease and it may cause filler material sedimentation in the composition during sample preparation and curing. Such sedimentation may cause inhomogeneous filler distribution in the cured thermoset.

If the cycloaliphatic epoxy resin used in the present invention is below the concentration of about 1 wt %, the thermal resistance of the cured thermoset may begin to decrease. Also, the composition viscosity may begin to increase and it may be difficult to fully degas the composition during sample preparation. Any residual bubbles and voids in the cured thermoset may decrease the electric properties of the thermoset such as its dielectric strength and partial discharge.

In one preferred embodiment, a cycloaliphatic epoxy resin may be used at from about 10 wt % to about 30 wt % of the epoxy resin mixture and from about 15 wt % to about 25 wt % of the epoxy resin mixture in another embodiment. For example, in another embodiment, the cycloaliphatic type epoxy resin may be a commercial product, such as E.R.L. 4221 which is an epoxy resin having an EEW of about 137 and commercially available from The Dow Chemical Company.

Other cycloaliphatic epoxy resins that may be used in the present invention may be any of the cycloaliphatic epoxy resins known in the art such as the cycloaliphatic epoxy resins described in Lee, H. and Neville, K., Handbook of Epoxy Resins, McGraw-Hill Book Company, New York, 1967, Chapter 2, pages 2-1 to 2-27, incorporated herein by reference.

The hardener useful in the curable formulation of the present invention may include for example one or more compounds having an anhydride functional group; and which reacts with oxirane groups to form a bond thereto and extends the polymer chain. In one embodiment, the anhydride hardener may include for example an anhydride hardener such as methyl tetrahydrophthalic anhydride (MTHPA). In another embodiment, the hardener useful in the present invention may be a combination of two or more anhydride hardeners. Other anhydride hardeners that may be used in the present invention may be any of the anhydride hardeners known in the art such as the anhydride hardeners described in Lee, H. and Neville, K., Handbook of Epoxy Resins, McGraw-Hill Book Company, New York, 1967, Chapter 2, pages 2-1 to 2-27, incorporated herein by reference.

The concentration of the anhydride hardener used in the present invention may range generally from about 6.5 wt % to about 15.5 wt % in one embodiment, from about 8 wt % to about 13.5 wt % in another embodiment, and from about 9 wt % to about 12 wt % in still another embodiment, based on the total weight of the composition.

If the hardener used in the present invention is above the concentration of about 15.5 wt %, the toughness and the mechanical strength of the cured thermoset may begin to decrease. Also the composition viscosity may begin to decrease and it may cause filler material sedimentation during sample preparation and curing. Such sedimentation may cause inhomogeneous filler distribution in the cured thermoset.

If the hardener used in the present invention is below the concentration of about 6.5 wt %, the thermal resistance of the cured thermoset may begin to decrease. Also, the composition viscosity may begin to increase and it may be difficult to fully degas the composition during sample preparation. Any residual bubbles and voids in the cured thermoset may decrease the electric properties of the thermoset such as its dielectric strength and partial discharge.

The equivalent ratio of anhydride to epoxy is from 0.75 to 0.85.

In one preferred embodiment, the anhydride used in the present invention may be MTHPA with an anhydride equivalent weight of about 166.

The filler useful in the present invention may include one or more filler materials known in the art. For example, the filler can be selected from an inorganic filler such as for example aluminum oxide, silica, wollastonite, talc, quartz, and mica; a flame retardant filler such as aluminum trihydroxide, magnesium hydroxide, and boehmite; or mixtures thereof. In one embodiment, the filler may include aluminum oxide filler such as for example aluminum oxide filler with an average dimension of about 15 microns.

The concentration of the filler used in the curable formulation of the present invention may range generally from about 60 wt % to about 80 wt % in one embodiment, from about 65 wt % to about 75 wt % in another embodiment, and from about 68 wt % to about 72 wt % in still another embodiment, based on the total weight of the composition.

If the filler used in the present invention is above the concentration of about 80 wt %, the toughness and the mechanical strength of the cured thermoset may begin to decrease. Also, the composition viscosity may begin to increase and it may be difficult to fully degas the composition during sample preparation. Any residual bubbles and voids in the cured thermoset may decrease the electric properties of the thermoset such as its dielectric strength and partial discharge.

If the filler used in the present invention is below the concentration of about 60 wt %, the Young's modulus, dielectric properties and dimension stability of the cured thermoset may begin to decrease. Also, the composition viscosity may begin to decrease and it may cause filler sedimentation during sample preparation and curing. Such sedimentation may cause inhomogeneous filler distribution in the cured thermoset.

The curing catalyst or accelerator useful in the curable formulation of the present invention accelerates a curing reaction between the epoxy resin and an epoxy-reactive compound (for example, the hardeners described above). In one embodiment, the curing catalyst or accelerator may include one or more known curing catalysts used for curing epoxy resins. For example, the curing catalyst may be ethyltriphenylphosphonium acetate, A-1 catalyst, or mixtures thereof. A-1 catalyst is a catalyst commercially available from The Dow Chemical Company.

The concentration of the curing catalyst or accelerator, when used in the curable formulation of the present invention, may range generally from 0.01 wt % to about 1 wt % in one embodiment, from about 0.01 wt % to about 0.25 wt % in another embodiment, and from about 0.01 wt % to about 0.1 wt % in still another embodiment, based on the weight of the hardener.

If the curing catalyst or accelerator when used in the present invention is above the concentration of about 1 wt %, the curing reactivity of the composition and the curing shrinkage of the composition may be high. This may cause an inhomogeneous curing degree in the resulting cured thermoset. Also this may shorten the pot life of the composition during sample preparation.

The curable epoxy resin composition or formulation according to the present invention may further include one or more additives selected from additional flame retardants, additional toughening agents, flexibilizers, curing inhibitors, wetting agents, colorants, thermoplastics, processing aids, dyes, UV-blocking compounds, and fluorescent compounds; or mixtures thereof. The above list is intended to be exemplary and not limiting.

The concentration of the additional additives is generally between 0 wt % to about 50 wt % in one embodiment, between about 0.01 wt % to about 20 wt % in another embodiment, between about 0.05 wt % to about 15 wt % in still another embodiment, and between about 0.1 wt % to about 10 wt % in yet another embodiment, based on the weight of the total composition. Below about 0.01 wt %, the additives generally do not provide any further significant advantage to the resultant thermoset product; and above about 20 wt %, the properties improvement brought by these additives remain relatively constant.

The preparation of the formulation of the present invention such as the process of mixing the compounds of the formulation , and/or any of the steps thereof, may be a batch process or a continuous process. The mixing equipment used in the process may be any vessel and ancillary equipment well known to those skilled in the art.

Properties such as epoxy resin viscosity and curable composition viscosity need to be adjusted to achieve good filler dispersion during preparation of the curable composition and to avoid filler sedimentation during the composition curing process. For example, in one embodiment, the epoxy viscosity at 120 °C for the final epoxy resin component of the composition may be from about 100 mPa.s to about 1000 mPa.s such that good filler dispersion is achieved.

In another embodiment, for example, the curable composition viscosity at 120 °C may be from about 200 mPa.s to about 800 mPa.s such that good casting capability is achieved and filler sedimentation is avoided.

The curing of the formulation of the present invention to form the cured composite and/or any of the steps thereof may be a batch or a continuous process. The curing equipment used in the process may be any vessel and ancillary equipment well known to those skilled in the art.

The cured thermoset resin product made from the curable formulation of the present invention may have several beneficial thermal and mechanical properties. For example, the Tg of the thermoset may be no less than about 145 °C in one embodiment and from about 145 °C to about 155 °C in another embodiment.

For example, the tensile strength at break of the thermoset may be no less than about 75 MPa in one embodiment and from about 75 MPa to about 85 MPa in another embodiment.

For example, the tensile strain at break of the thermoset may be no less than about 0.8 % in one embodiment and from about 0.8 % to about 1.2 % in another embodiment.

For example, the Young's modulus of the thermoset may be no less than about 11500 MPa in one embodiment and from about 11500 MPa to about 13000 MPa in another embodiment.

For example the impact strength of the thermoset may be no less than about 15 kJ/m2 in one embodiment and from about 15 kJ/m2 to about 18 kJ/m2 in another embodiment.

For example, the fracture toughness of the thermoset may be no less than about 1.8 MPa.m1/2 in one embodiment and from about 1.8 MPa.m1/2 to about 2.4 MPa.m1/2 in another embodiment.

The process useful in the present invention for producing the insulator article or product may include any of the various processes known in the industry for example as described in WO2010106084(A1), incorporated herein by reference. In general, the steps of manufacturing the insulator product includes the steps of: (a) mixing the combination of epoxy resin compounds, the hardener, the filler and the optional curing catalyst to form the curable formulation of the present invention at a temperature from about 100 °C to about 140 °C; (b) degassing the composition at a temperature of from about 100 °C to about 140 °C under vacuum (generally, less than (<) about 10 mbar in one embodiment and from about 1 mbar to about 10 mbar in another embodiment); (c) pouring the composition into a mould at a temperature of from about 100 °C to about 140 °C under vacuum (generally, < about 30 mbar in one embodiment and from about 1 mbar to about 30 mbar in another embodiment); and (d) placing the mould in an oven to cure the composition at a predetermined temperature and a predetermined period of time.

Generally, the composition of the present invention can be cured at a temperature of from about room temperature (about 25 °C) to about 280 °C in one embodiment; from about 50 °C to about 280 °C in another embodiment; and from about 100 °C to about 200 °C in still another embodiment; and for a curing time within the range of from about 30 minutes to about 40 hours in one embodiment.

In one embodiment, the curable epoxy resin composition of the present invention is suitable for preparing an insulator for a high-voltage gas insulated switchgear. The curable epoxy resin composition and the cured thermoset made therefrom display a superior balance of different properties including resin viscosity, composition viscosity, glass transition temperature, tensile strength, impact strength and fracture toughness.

For example, when the curable epoxy resin composition is used for manufacturing insulators for high-voltage gas insulated switchgears, the final thermoset requires minimum thermal and mechanical properties based on industrial design requirements, including for example a glass transition temperature of generally greater than or equal to (>=) about 145 °C in one embodiment and from about 145 °C to about 155 °C in another embodiment; a tensile strength of generally >= about 75 MPa in one embodiment and from about 75 MPa to about 85 MPa in another embodiment; an elongation of generally >= about 0.8 % in one embodiment and from about 0.8 % to about 1.2 % in another embodiment; a Young's Modulus of generally >= about 11500 MPa in one embodiment and from about 11500 MPa to about 13000 MPa in another embodiment; an impact strength of generally >= about 15 kJ/m$^2$ in one embodiment and from about 15 kJ/m$^2$ to about 18 kJ/m$^2$ in another embodiment; and a fracture toughness of generally >= about 1.8 MPa.m$^{1/2}$ in one embodiment and from about 1.8 MPa.m$^{1/2}$ to about 2.4 MPa.m$^{1/2}$ in another embodiment.

EXAMPLES

The following examples and comparative examples further illustrate the present invention in detail but are not to be construed to limit the scope thereof.

In the following Examples, various terms and designations were used such as for example:

"MTHPA" stands for methyl tetrahydrophthalic anhydride.

"THPA" stands for tetrahydrophthalic anhydride.

"PA" stands for phthalic anhydride.

D.E.R. 671 is bisphenol A type solid epoxy resin commercially available from The Dow Chemical Company.

D.E.N. 438 is phenol novolac type epoxy resin commercially available from The Dow Chemical Company.

E.R.L. 4221 is cycloaliphatic epoxy resin commercially available from The Dow Chemical Company.

D.E.R. 383 is bisphenol A type liquid epoxy resin commercially available from The Dow Chemical Company.

CT5531 is bisphenol A type semi-solid epoxy resin commercially available from Huntsman.

Standard analytical equipment and methods were used to test the performance of composite rods prepared in the Examples. For instance, the following procedures were carried out on the composite rods described in the Examples:

General Procedure for Preparing the Epoxy Resin Composition

A resin composition was prepared and cured according to the following process. The epoxy resin was blended into homogeneous mixture at 120 °C by using a high shear disperser. MTHPA and A-1 catalyst were added and followed by dispersion (500 RPM) at 120 °C for 30 minutes (min). Aluminum oxide was added into the mixture and followed by dispersion (500 RPM) at 130 °C for 30 min. After dispersion, the composition was degassed at 120 °C for 15 min in a vacuum oven. The degassed composition was pulled into steel molds with 4 mm and 10 mm thickness to prepare cured plaques. The curing process was carried out at 100 °C for 12 hours (hr) and then 160 °C for 16 hr. All mechanical testing specimens were cut from the plaques by water-jet machining.

The Glass Transition Temperature (Tg)

The Tg was measured by using a Q-2000 differential scanning calorimeter (DSC) from TA Instruments. A small sample (around 8-10 mg) was placed into T-zero pan. Three scans were obtained for each sample, which were used to eliminate thermal history in curing process (1$^{st}$ scan) and to check for complete cure of each sample (3$^{rd}$ scan). The Tg data obtained from this testing and reported in Table I was from the second scan. The first scan was from 30 °C to 180 °C at 20 °C /min. The second and third scan were both from 30 °C to 230 °C at 10 °C /min. The instrument was purged using nitrogen gas.

Dynamic Viscosity (at 120 °C)

Dynamic viscosity was measured by using ARES-G2 rheometer from TA instruments. A small sample (around 0.5 ml) was used. The measurement was done in the steady flow mode by using two 25 mm parallel plates. The measurement was done at 120 °C with a shear rate of 10 s$^{-1}$.

Tensile Test

The tensile test was performed on dog-bone shape, type I, tensile bars according to ISO 527. The test was conducted at 25 °C with a loading speed of 5 mm/min on an Instron 5566 machine.

Impact Test

The impact test was performed on un-notched charpy specimen according to ISO 179. The impact test was conducted at 25 °C on a Resil Impactor (Type: Ceast 6960).

Fracture Toughness Test

The fracture toughness test was performed in terms of critical-stress-intensity factor, $K_{1c}$, following the ASTM D 5045-99 test method. This testing method involved a notched specimen (single-edge notched bending, SENB) that has been pre-cracked in tension. Cracks were initiated by slightly tapping a new, dry ice chilled razor blade in a machined notch. Tests were conducted on an INSTRON 5566 frame in flexural mode. Six to ten samples were tested for each formulation. $K_{1c}$ was calculated from the following equation:

$$K_{1c} = \frac{P_{max}}{BW^{1/2}} f(a/W)$$

where $P_{max}$ was the maximum load at failure, $B$ was the sample thickness, $W$ was the overall width, $a$ was the crack length, and $f(a/W)$ was an expression accounting for the geometry of the sample identified in ASTM D 5045-99.

Examples 1 and 2 and Comparative Examples A-H

Formulations of curable epoxy resin compositions which included an aluminum oxide filler were used in the examples described in Table I. These formulations include Example 1, Example 2, and Comparative Examples A-H as described in Table I.

Examples 3 and Comparative Example I

Formulations of curable epoxy resin compositions which included a silica filler were used in the examples described in Table I. These formulations include Example 3 and Comparative Example I as described in Table I.

Table I

| | Example | Ex. 1 | Ex. 2 | Ex. 3 | Comp. Ex. A | Comp. Ex. B | Comp. Ex. C | Comp. Ex. D | Comp. Ex. E | Comp. Ex. F | Comp. Ex. G | Comp. Ex. H | Comp. Ex. I |
|---|---|---|---|---|---|---|---|---|---|---|---|---|---|
| Number of Epoxy Resin Used in Formulation | | 3 | 3 | 3 | 3 | 2 | 2 | 2 | 2 | 2 | 2 | 3 | 2 |
| COMPONENTS | EEW | | | | | | | | | | | | |
| D.E.R. 671 (wt %) | 500 | 59.3 | 50 | 50 | 50 | 50 | 50 | 80 | -- | 60 | | | 50 |
| D.E.N. 438 (wt %) | 174 | 14.4 | 30 | 30 | 30 | -- | -- | -- | 50 | -- | | 5 | -- |
| E.R.L. 422 (wt %)1 | 137 | 26.3 | 20 | 20 | 20 | 50 | 50 | 20 | 50 | -- | 10 | 10 | 50 |
| D.E.R. 383 (wt %) | 186 | -- | -- | -- | -- | -- | -- | -- | -- | 40 | | | -- |
| CT5531 (wt %) | 385 | -- | -- | -- | -- | -- | -- | -- | -- | -- | 90 | 85 | -- |
| MTHPA[a] (wt %) | 166 | 53.6 | 51.6 | 51.6 | 61.9 | 58.0 | 69.5 | 45.7 | 92.04 | 39.6 | | | 69.5 |
| THPA[a] (wt %) | 152 | | | | | | | | | 44 | | | |
| PA[a] (wt %) | 148 | | | | | | | | | | | 35 | |
| $Al_2O_3$ filler (wt %) | | 70 | 70 | | 70 | 70 | 70 | 70 | 70 | 70 | 70 | 70 | |
| $SiO_2$ Filler (wt %) | | | | 60 | | | | | | | | | 60 |
| PROPERTIES | | | | | | | | | | | | | |
| Equivalent ratio of epoxy to anhydride | | 1:0.82 | 1:0.75 | 1:0.75 | 1:0.90 | 1:0.75 | 1:0.90 | 1:0.90 | 1:0.85 | 1:0.90 | 1:0.94 | 1:0.75 | 1:0.90 |
| Tg (°C) | | 156 | 145 | 147 | 167 | 166 | 184 | 146 | 205 | 105 | 120 | 135 | 185 |
| Neat epoxy viscosity at °C (mPa.s) | | 356 | 285 | 285 | 285 | 108 | 108 | 878 | 12 | 378 | 453 | 254 | 108 |
| Composition viscosity at °C (mPa.s) | | 358 | 535 | 785 | 235 | 254 | 135 | 2436 | 35 | 585 | 731 | 654 | 453 |
| Tensile strength at break (Mpa) | | 78 | 86 | 88 | 81 | 75 | 73 | 70 | 72 | 62 | 65 | 75 | 75 |
| Elongation at break (%) | | 0.9 | 1.1 | 1.2 | 0.8 | 0.7 | 0.65 | 1.3 | 0.55 | 0.65 | 0.65 | 0.8 | 0.75 |

EP 2 831 172 B1

(continued)

| | Example | Ex. 1 | Ex. 2 | Ex. 3 | Comp. Ex. A | Comp. Ex. B | Comp. Ex. C | Comp. Ex. D | Comp. Ex. E | Comp. Ex. F | Comp. Ex. G | Comp. Ex. H | Comp. Ex. I |
|---|---|---|---|---|---|---|---|---|---|---|---|---|---|
| Young's Modulus (Mpa) | | 11500 | 12500 | 10500 | 12100 | 11800 | 12300 | 11000 | 12700 | 11500 | 11300 | 11500 | 10200 |
| Impact strength (kJ/m$^2$) | | 15.3 | 17.1 | 18.2 | 13.4 | 13.7 | 10.5 | 20.5 | 9.1 | 10.7 | 11.4 | 13.7 | 12.6 |
| Fracture toughness ($K_{1c}$) (MPa.m$^{1/2}$) | | 1.8 | 2.2 | 2.3 | 1.5 | 1.5 | 1.3 | 2.4 | 1.1 | 1.3 | 1.5 | 1.8 | 1.4 |
| [a]MTHPA stands for methyl tetrahydrophthalia anhydride; THPA stands for tetrahydrophthalic anhydride; PA stands for phthalic anhydride. | | | | | | | | | | | | | |

The results from Table I above show that Comparative Example A used an epoxy to anhydride ratio of 1:0.90, while embodiments of the present invention, Example 1 and Example 2, used an epoxy to anhydride ratio of 1:0.85 and 1:0.75, respectively.

When compared with Comparative Example A, Examples 1 and 2 lead to higher toughness as confirmed by the higher fracture toughness, impact strength and elongation at break. The Tg of Examples 1 and 2 is reduced somewhat relative to Comparative Example A. But this reduction in Tg is acceptable for use in applications such as GIS.

The results from Table I above show that Comparative Examples B to D used a combination of two types of epoxy resins, while embodiments of the present invention (Examples 1 and 2) used a combination of three types of epoxy resins. In Comparative Examples B to D, no novolac epoxy resin was used.

When compared with Comparative Examples B to D, Examples 1 and 2 lead to higher mechanical strength as confirmed by the tensile strength at break. In addition, Examples 1 and 2 lead to higher toughness as confirmed by the higher fracture toughness, impact strength and elongation at break. The Tg of Examples 1 and 2 is reduced somewhat relative to Comparative Examples B to D. But this reduction in Tg is acceptable for use in applications such as GIS. Although Comparative Example D showed relatively high toughness, the much higher resin viscosity made the sample of Comparative Example D very poor for processability.

The results from Table I show that Comparative Example E used a combination of two types of epoxy resins, while embodiments of the present invention (Examples 1 and 2) used a combination of three types of epoxy resins. In Comparative Example E, no solid epoxy resin was used.

When compared with Comparative Example E, Examples 1 and 2 lead to higher mechanical strength as confirmed by the tensile strength at break. In addition, Examples 1 and 2 lead to significant higher toughness as confirmed by the higher fracture toughness, impact strength and elongation at break. The Tg of Examples 1 and 2 is reduced somewhat relative to Comparative Example E. But this reduction in Tg is acceptable for use in applications such as GIS. In addition, the epoxy viscosity and composition viscosity of Comparative Example E are too low to avoid filler sedimentation during dispersion and curing process.

The results from Table I above show that Comparative Example F used a combination of two types of epoxy resins, while embodiments of the present invention (Examples 1 and 2) used a combination of three types of epoxy resins. In Comparative Example F, neither novolac nor cycloaliphatic epoxy resin was used.

When compared with Comparative Example F, Examples 1 and 2 lead to higher mechanical strength as confirmed by the tensile strength at break. In addition, Example 1 and 2 lead to significant higher toughness as confirmed by the higher fracture toughness, impact strength and elongation at break. The Tg of Comparative Example F is far below an acceptable lower limit.

The results from Table I show that neither Comparative Example G nor Comparative Example H used a solid epoxy resin with an EEW larger than 400.

When compared with Comparative Examples G and H, Examples 1 and 2 lead to a much higher mechanical strength as confirmed by the tensile strength at break. Also, Examples 1 and 2 lead to a significant higher toughness as confirmed by the higher fracture toughness, impact strength and elongation at break. The Tg of Comparative Examples G and H is below an acceptable lower limit.

The results from Table I show that Comparative Example I used a combination of two types of epoxy resins, while embodiments of the present invention (Example 3) use a combination of three types of epoxy resins. In Comparative Example I, no novolac epoxy resin was used.

When compared with Comparative Example I, Example 3 leads to higher mechanical strength as confirmed by the tensile strength at break. In addition, Example 3 leads to higher toughness as confirmed by the higher fracture toughness, impact strength and elongation at break. The Tg of Example 3 is somewhat reduced relative to Comparative Example I. But this reduction in Tg is acceptable for use in applications such as GIS.

## Claims

1. A curable epoxy resin formulation comprising:

    (A) an epoxy resin composition comprising a mixture of:

        (A1) at least one solid epoxy resin,
        (A2) at least one novolac epoxy resin, and
        (A3) at least one cycloaliphatic epoxy resin;

    (B) at least one anhydride hardener;
    (C) at least one filler; and

(D) optionally, at least one catalyst or at least one accelerator,

wherein, "solid epoxy resin" means an epoxy resin with a softening point no less than 50 °C; and the formulation contains an epoxy group to anhydride group ratio of from 1:0.75 to 1:0.85.

2. The curable epoxy resin formulation of claim 1, wherein the solid epoxy resin is a bisphenol A type epoxy resin.

3. The curable epoxy resin formulation of claim 2, wherein the bisphenol A type epoxy resin has a softening point of no less than about 50 °C and an epoxide equivalent weight of from about 400 to about 600.

4. The curable epoxy resin formulation of claim 1, wherein the novolac epoxy resin is a condensate of a phenol with formaldehyde that is obtained under acid conditions.

5. The curable epoxy resin formulation of claim 4, wherein the novolac epoxy resin is a phenol novolac, a bisphenol A novolac, a cresol novolac, or a mixture thereof.

6. The curable epoxy resin formulation of claim 1, wherein the cycloaliphatic epoxy resin is a hydrocarbon compound comprising at least one non-aryl hydrocarbon ring structure and at least one epoxy group.

7. The curable epoxy resin formulation of claim 1, wherein the anhydride hardener is a compound having an anhydride functional group, adapted to react with an oxirane group to form a bond thereto and adapted to extend a polymer chain.

8. The curable epoxy resin formulation of claim 1, wherein the filler is an inorganic filler selected from the group consisting of aluminum oxide, silica, wollastonite, talc, quartz, mica, or mixtures thereof; or wherein the filler is inorganic flame retardant filler selected from the group consisting of aluminum trihydroxide, magnesium hydroxide, boehmite, or mixtures thereof.

9. The curable epoxy resin formulation of claim 1, wherein the concentration of the solid epoxy resin is from about 5 weight percent to about 16 weight percent; wherein the concentration of the novolac epoxy resin is from about 2.5 weight percent to about 11 weight percent; wherein the concentration of the cycloaliphatic epoxy resin is from about 1 weight percent to about 8 weight percent; wherein the concentration of the anhydride hardener is from about 6.5 weight percent to about 15.5 weight percent; and wherein the concentration of the filler is from about 60 weight percent to about 80 weight percent.

10. The curable epoxy resin formulation of claim 1, wherein the concentration of the catalyst or accelerator is from about 0.01 weight percent to about 1 weight percent based on the weight of the hardener.

11. An insulator for a high-voltage gas insulated switchgear manufactured from the formulation of claim 1, wherein "high-voltage" means a voltage level of 110 kV and greater.

12. A process for preparing a curable epoxy resin formulation comprising admixing:

(A) an epoxy resin composition comprising a mixture of:

(A1) at least one solid epoxy resin,
(A2) at least one novolac epoxy resin, and
(A3) at least one cycloaliphatic epoxy resin;

(B) at least one anhydride hardener;
(C) at least one filler; and
(D) optionally, at least one catalyst or at least one accelerator,

such that the formulation contains an epoxy group to anhydride group ratio of from 1:0.75 to 1:0.85, and wherein "solid epoxy resin" means an epoxy resin with a softening point no less than 50 °C.

13. A process for manufacturing an insulator for a high-voltage gas insulated switchgear comprising the steps of:

(I) admixing and degassing

(A) an epoxy resin composition comprising a mixture of:

(A1) at least one solid epoxy resin,
(A2) at least one novolac epoxy resin, and
(A3) at least one cycloaliphatic epoxy resin;

(B) at least one anhydride hardener;
(C) at least one filler; and
(D) optionally, at least one catalyst or at least one accelerator; and

(II) curing the mixture at temperature of from about 100 °C to about 170 °C,

wherein, "solid epoxy resin" means an epoxy resin with a softening point no less than 50 °C; "high-voltage" means a voltage level of 110 kV and greater; and the mixture contains an epoxy group to anhydride group ratio of from 1:0.75 to 1:0.85.

14. An insulator for a high-voltage gas insulated switchgear produced by the process of claim 13.


**Patentansprüche**

1. Eine härtbare Epoxidharzformulierung, beinhaltend:

(A) eine Epoxidharzzusammensetzung, beinhaltend eine Mischung von:

(A1) mindestens einem festen Epoxidharz,
(A2) mindestens einem Novolak-Epoxidharz, und
(A3) mindestens einem cycloaliphatischen Epoxidharz;

(B) mindestens einem Anhydridhärtungsmittel;
(C) mindestens einem Füllstoff; und
(D) wahlweise mindestens einem Katalysator oder mindestens einem Beschleuniger,

wobei "festes Epoxidharz" ein Epoxidharz mit einem Erweichungspunkt von nicht weniger als 50 °C bedeutet; und die Formulierung ein Verhältnis von Epoxidgruppe zu Anhydridgruppe von 1 : 0,75 bis 1 : 0,85 enthält.

2. Härtbare Epoxidharzformulierung gemäß Anspruch 1, wobei das feste Epoxidharz ein Epoxidharz vom Bisphenol A-Typ ist.

3. Härtbare Epoxidharzformulierung gemäß Anspruch 2, wobei das Epoxidharz vom Bisphenol A-Typ einen Erweichungspunkt von nicht weniger als etwa 50 °C und ein Epoxidäquivalentgewicht von etwa 400 bis etwa 600 aufweist.

4. Härtbare Epoxidharzformulierung gemäß Anspruch 1, wobei das Novolak-Epoxidharz ein Kondensat eines Phenols mit Formaldehyd ist, das unter sauren Bedingungen erhalten wird.

5. Härtbare Epoxidharzformulierung gemäß Anspruch 4, wobei das Novolak-Epoxidharz ein Phenol-Novolak, ein Bisphenol-A-Novolak, ein Kresol-Novolak oder eine Mischung davon ist.

6. Härtbar Epoxidharzformulierung gemäß Anspruch 1, wobei das cycloaliphatische Epoxidharz eine Kohlenwasserstoffverbindung ist, beinhaltend mindestens eine nicht-Aryl-Kohlenwasserstoffringstruktur und mindestens eine Epoxidgruppe.

7. Härtbare Epoxidharzformulierung gemäß Anspruch 1, wobei das Anhydridhärtungsmittel eine Verbindung mit einer funktionellen Anhydridgruppe ist, angepasst, um mit einer Oxirangruppe zu reagieren, um eine Bindung dazu zu bilden, und angepasst, um eine Polymerkette zu verlängern.

8. Härtbare Epoxidharzformulierung gemäß Anspruch 1, wobei der Füllstoff ein anorganischer Füllstoff ist, ausgewählt ist aus der Gruppe, bestehend aus Aluminiumoxid, Siliciumdioxid, Wollastonit, Talk, Quartz, Glimmer oder Mischungen davon; oder wobei der Füllstoff ein anorganisches Flammschutzmittel ist, ausgewählt ist aus der Gruppe, bestehend aus Aluminiumtrihydroxid, Magnesiumhydroxid, Böhmit oder Mischungen davon.

9. Härtbare Epoxidharzformulierung gemäß Anspruch 1, wobei die Konzentration des festen Epoxidharzes von etwa 5 Gewichtsprozent bis etwa 16 Gewichtsprozent beträgt; wobei die Konzentration des Novolak-Epoxidharzes von etwa 2,5 Gewichtsprozent bis etwa 11 Gewichtsprozent beträgt; wobei die Konzentration des cycloaliphatischen Epoxidharzes von etwa 1 Gewichtsprozent bis etwa 8 Gewichtsprozent beträgt; wobei die Konzentration des Anhydridhärtungsmittels von etwa 6,5 Gewichtsprozent bis etwa 15,5 Gewichtsprozent beträgt; und wobei die Konzentration des Füllstoffs von etwa 60 Gewichtsprozent bis etwa 80 Gewichtsprozent beträgt.

10. Härtbare Epoxidharzformulierung gemäß Anspruch 1, wobei die Konzentration des Katalysators oder des Beschleunigers, bezogen auf das Gewicht des Härtungsmittels, von etwa 0,01 Gewichtsprozent bis etwa 1 Gewichtsprozent beträgt.

11. Ein Isolator für eine gasisolierte Hochspannungs-Schaltanlage, hergestellt aus der Formulierung gemäß Anspruch 1, wobei "Hochspannung" ein Spannungsniveau von 110 kV und mehr bedeutet.

12. Ein Verfahren zum Zubereiten einer härtbaren Epoxidharzformulierung, beinhaltend das Vermischen von Folgendem:

(A) einer Epoxidharzzusammensetzung, beinhaltend eine Mischung von:

(A1) mindestens einem festen Epoxidharz,
(A2) mindestens einem Novolak-Epoxidharz, und
(A3) mindestens einem cycloaliphatischen Epoxidharz;

(B) mindestens eines Anhydridhärtungsmittels;
(C) mindestens eines Füllstoffs; und
(D) wahlweise mindestens eines Katalysators oder mindestens eines Beschleunigers,

derart, dass die Formulierung ein Verhältnis (von) Epoxidgruppe zu Anhydridgruppe von 1 : 0,75 bis 1 : 0,85 enthält, und wobei "festes Epoxidharz" ein Epoxidharz mit einem Erweichungspunkt von nicht weniger als 50 °C bedeutet.

13. Ein Verfahren zum Herstellen eines Isolators für eine gasisolierte Hochspannungs-Schaltanlage, beinhaltend die folgenden Schritte:

(I) Vermischen und Entgasen

(A) einer Epoxidharzzusammensetzung, beinhaltend eine Mischung von:

(A1) mindestens einem festen Epoxidharz,
(A2) mindestens einem Novolak-Epoxidharz, und
(A3) mindestens einem cycloaliphatischen Epoxidharz;

(B) mindestens eines Anhydridhärtungsmittels;
(C) mindestens eines Füllstoffs; und
(D) wahlweise mindestens eines Katalysators oder mindestens eines Beschleunigers; und

(II) Härten der Mischung bei einer Temperatur von etwa 110 °C bis etwa 170 °C,

wobei "festes Epoxidharz" ein Epoxidharz mit einem Erweichungspunkt von nicht weniger als 50 °C bedeutet; "Hochspannung" ein Spannungsniveau von 110 kV und mehr bedeutet; und die Mischung ein Verhältnis von Epoxidgruppe zu Anhydridgruppe von 1 : 0,75 bis 1 : 0,85 enthält.

14. Ein Isolator für eine gasisolierte Hochspannungs-Schaltanlage, produziert durch das Verfahren gemäß Anspruch 13.

**Revendications**

1. Une formulation de résine époxy durcissable comprenant :

   (A) une composition de résine époxy comprenant un mélange :

      (A1) d'au moins une résine époxy solide,
      (A2) d'au moins une résine époxy novolaque, et
      (A3) d'au moins une résine époxy cycloaliphatique ;

   (B) au moins un durcisseur anhydride ;
   (C) au moins une charge ; et
   (D) facultativement, au moins un catalyseur ou au moins un accélérateur,

   dans laquelle, « résine époxy solide » désigne une résine époxy avec un point de ramollissement n'étant pas inférieur à 50 °C ; et la formulation contenant un rapport des groupes époxy aux groupes anhydride allant de 1/0,75 à 1/0,85.

2. La formulation de résine époxy durcissable de la revendication 1, dans laquelle la résine époxy solide est une résine époxy de type bisphénol A.

3. La formulation de résine époxy durcissable de la revendication 2, dans laquelle la résine époxy de type bisphénol A a un point de ramollissement n'étant pas inférieur à environ 50 °C et un poids équivalent d'époxyde allant d'environ 400 à environ 600.

4. La formulation de résine époxy durcissable de la revendication 1, dans laquelle la résine époxy novolaque est un condensat d'un phénol avec du formaldéhyde qui est obtenu dans des conditions acides.

5. La formulation de résine époxy durcissable de la revendication 4, dans laquelle la résine époxy novolaque est une novolaque phénol, une novolaque bisphénol A, une novolaque crésol, ou un mélange de celles-ci.

6. La formulation de résine époxy durcissable de la revendication 1, dans laquelle la résine époxy cycloaliphatique est un composé hydrocarbure comprenant au moins une structure d'anneau non-arylhydrocarbure et au moins un groupe époxy.

7. La formulation de résine époxy durcissable de la revendication 1, dans laquelle le durcisseur anhydride est un composé ayant un groupe fonctionnel anhydride, adapté à réagir avec un groupe oxirane afin de former une liaison avec celui-ci et adapté à étendre une chaîne polymère.

8. La formulation de résine époxy durcissable de la revendication 1, dans laquelle la charge est une charge inorganique sélectionnée dans le groupe constitué de l'oxyde d'aluminium, de la silice, de la wollastonite, du talc, du quartz, du mica, ou de mélanges de ceux-ci ; ou dans laquelle la charge est une charge ignifugeante inorganique sélectionnée dans le groupe constitué du trihydroxyde d'aluminium, de l'hydroxyde de magnésium, de la boehmite, ou de mélanges de ceux-ci.

9. La formulation de résine époxy durcissable de la revendication 1, dans laquelle la concentration de la résine époxy solide va d'environ 5 pour cent en poids à environ 16 pour cent en poids ; dans laquelle la concentration de la résine époxy novolaque va d'environ 2,5 pour cent en poids à environ 11 pour cent en poids ; dans laquelle la concentration de la résine époxy cycloaliphatique va d'environ 1 pour cent en poids à environ 8 pour cent en poids ; dans laquelle la concentration du durcisseur anhydride va d'environ 6,5 pour cent en poids à environ 15,5 pour cent en poids ; et dans laquelle la concentration de la charge va d'environ 60 pour cent en poids à environ 80 pour cent en poids.

10. La formulation de résine époxy durcissable de la revendication 1, dans laquelle la concentration du catalyseur ou de l'accélérateur va d'environ 0,01 pour cent en poids à environ 1 pour cent en poids rapporté au poids du durcisseur.

11. Un isolateur pour un appareillage de commutation isolé au gaz haute tension fabriqué à partir de la formulation de la revendication 1, dans lequel « haute tension » désigne un niveau de tension de 110 kV et plus.

12. Un procédé pour préparer une formulation de résine époxy durcissable comprenant l'admixtion :

(A) d'une composition de résine époxy comprenant un mélange :

(A1) d'au moins une résine époxy solide,
(A2) d'au moins une résine époxy novolaque, et
(A3) d'au moins une résine époxy cycloaliphatique ;

(B) d'au moins un durcisseur anhydride ;
(C) d'au moins une charge ; et
(D) facultativement, d'au moins un catalyseur ou d'au moins un accélérateur,

de telle sorte que la formulation contienne un rapport des groupes époxy aux groupes anhydride allant de 1/0,75 à 1/0,85, et dans lequel « résine époxy solide » désigne une résine époxy avec un point de ramollissement n'étant pas inférieur à 50 °C.

13. Un procédé pour fabriquer un isolateur pour un appareillage de commutation isolé au gaz haute tension comprenant les étapes :

(I) d'admixtion et de dégazage

(A) d'une composition de résine époxy comprenant un mélange :

(A1) d'au moins une résine époxy solide,
(A2) d'au moins une résine époxy novolaque, et
(A3) d'au moins une résine époxy cycloaliphatique ;

(B) d'au moins un durcisseur anhydride ;
(C) d'au moins une charge ; et
(D) facultativement, d'au moins un catalyseur ou d'au moins un accélérateur ; et

(II) de durcissement du mélange à une température allant d'environ 100 °C à environ 170 °C,

dans lequel, « résine époxy solide » désigne une résine époxy avec un point de ramollissement n'étant pas inférieur à 50 °C ; « haute tension » désigne un niveau de tension de 110 kV et plus ; et le mélange contient un rapport des groupes époxy aux groupes anhydride allant de 1/0,75 à 1/0,85.

14. Un isolateur pour un appareillage de commutation isolé au gaz haute tension produit par le procédé de la revendication 13.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2755666 B
- JP 2103220 A
- JP 2011001424 A
- JP 3247619 A
- JP 03200858 A
- WO 2010106084 A1

**Non-patent literature cited in the description**

- **LEE, H. ; NEVILLE, K.** Handbook of Epoxy Resins. McGraw-Hill Book Company, 1967, 2-1-2-27